# EUROPÄISCHE PATENTSCHRIFT

(11) **EP 2 083 455 B1**
(45) Veröffentlichungstag und Bekanntmachung des Hinweises auf die Patenterteilung: **22.02.2012**
(21) Anmeldenummer: 09151415.8
(22) Anmeldetag: 27.01.2009
(51) Int. Cl.: H01L 41/09

(54) **Schubaktuator und mit einem solchen Schubaktuator versehener Träger**
Shear actuator and beam equipped with such a shear actuator
Actionneur de poussée et support comprenant un tel actionneur de poussée

(30) Priorität: 28.01.2008 DE 102008006296
(43) Veröffentlichungstag der Anmeldung: 29.07.2009
(73) Patentinhaber: Deutsches Zentrum für Luft- und Raumfahrt e.V., 51147 Köln (DE)
(72) Erfinder: Natterer, Franz Josef, 38100 Braunschweig (DE); Jahn, Steffen, 38108 Braunschweig (DE)
(74) Vertreter: Rehberg Hüppe + Partner

(56) Entgegenhaltungen:
- EP-A- 1 848 046
- US-A- 5 869 189
- US-A1- 2003 218 403
- US-A1- 2007 200 468
- US-B2- 6 629 341

## Beschreibung

### TECHNISCHES GEBIET DER ERFINDUNG

Die Erfindung bezieht sich auf einen Schubaktuator mit einem aktiven Flächenmaterial, das in einer in seiner Haupterstreckungsebene verlaufenden Verformungshauptrichtung auf Expansion und/oder Kontraktion ansteuerbar ist. Weiterhin bezieht sich die vorliegende Erfindung auf einen Träger mit einem Steg und mit zwei durch den Steg verbundenen Gurten. Ein solcher Träger kann z. B. als Holm oder Spant eines Fluggeräts Verwendung finden.

### STAND DER TECHNIK

Aktive Materialien, die in ihrer konkreten Ausgestaltung auch als Aktuatoren ausgezeichnet werden, werden vielfach auf eine Primärstruktur aufgebracht oder in diese integriert, die bereits als solche in der Lage ist, die auftretenden Strukturlasten passiv abzustützen. Bei derartiger Funktionstrennung von aktiver und passiver Struktur muss nicht nur die passive Struktur die vollen Strukturlasten aufnehmen können, sondern auch die aktive Struktur muss stark dimensioniert werden, weil die aktive gegen die passive Struktur arbeiten muss. Eine resultierende Verformung der passiven Struktur wird dabei durch das Verhältnis der aktiven und passiven Steifigkeit begrenzt. D. h., die erzielbare freie Verformung ist umso geringer, desto größer das Steifigkeitsverhältnis von passiver und aktiver Struktur ist. Dies ist Ausdruck der Tatsache, dass die passive Struktur den größten Teil der Verformungsenergie aufnimmt, um überhaupt verformt zu werden.

Aus der US 6,629,341 B2 und aus der US 4,197,798 B2 sind aktive Flächenmaterialien bekannt, die als Schubaktuatoren mit den Merkmalen der eingangs beschriebenen Art einsetzbar sind. Dabei bauen diese bekannten aktiven Flächenmaterialien auf nebeneinander angeordneten piezokeramischen Fasern auf, die durch planparallel zu der Ebene der piezokeramischen Fasern verlaufende Elektrodenanordnungen mit elektrischen Feldern beaufschlagt werden. In den Elektrodenanordnungen greifen fingerartige Elektroden entgegen gerichteter Polarität quer zu der Haupterstreckungsrichtung der piezokeramischen Fasern ineinander. Die resultierenden elektrischen Felder verlaufen mit sich über jede Elektrode hinweg umkehrender Polarität in ausreichendem Maße in der Haupterstreckungsrichtung der piezoelektrischen Fasern, um diese mit einer an die Elektroden angelegten Spannung auf eine Längenänderung, d. h. Expansion oder Kontraktion, anzusteuern. Hieraus resultiert ein Druck bzw. Zug zwischen den Enden der piezoelektrischen Fasern. Die piezoelektrischen Fasern können bei einem rechteckigen Flächenmaterial bekanntermaßen in Querrichtung, in Längsrichtung oder aber diagonal verlaufen. Entsprechende aktive Flächenmaterialien sind von der Smart Material GmbH, Dresden, (www.smart-material.com) als so genannte "Macro Fibre Composites" kommerziell erhältlich. Dabei sind Ausführungsformen verfügbar, die neben einem Aktuatorbereich auch einen grundsätzlich gleich aufgebauten Sensorbereich in derselben Haupterstreckungsebene aufweisen, um Verformungen der "Macro Fibre Composites" bzw. einer diese umfassenden Struktur zu erfassen, In ihren bekannten Verwendungen als Schubaktuatoren werden die "Macro Fibre Composites" flach auf ein passives Trägermaterial aufgeklebt, das direkt Teil einer beispielsweise in Hinblick auf Schwingungen zu dämpfenden Struktur sein kann.

In vielen technischen Bereichen kommen Träger mit einem Steg zum Einsatz, der zwei Gurte miteinander verbindet. Dabei können diese beiden Gurte, die bei vertikaler Ausrichtung des Stegs auch als Obergurt und als Untergurt bezeichnet werden, jeweils mittig durch den Steg abgestützt sein, woraus ein so genannter Doppel-T-Träger resultiert. Die Gurte können aber auch jeweils endseitig durch den Steg abgestützt sein, was der Konfiguration eines so genannten "U-Trägers" entspricht. Auch andere Konfigurationen sind möglich. Bei all diesen Trägern mit einem zwei Gurte verbindenden Steg, der aufgrund seines englischen Namens auch als "Web" bezeichnet wird, wird der Steg bei einer Biegebeanspruchung des jeweiligen Trägers in Querrichtung zu den Haupterstreckungsebenen der Gurte auf Schub beansprucht. Dabei verteilt sich die Schubbelastung über die gesamte Fläche des Stegs und wird entsprechend großflächig abgestützt. Bei einem herkömmlichen Träger mit passivem Steg sorgt dieser passive Steg so für eine erhebliche Erhöhung der Biegesteifigkeit. Durch Aktuatoren, die auf einen herkömmlichen passiven Träger aufgebracht werden, kann dieser, wegen seiner gegenüber den aktiven Komponenten sehr hohen Steifigkeit, nicht sinnvoll verformt werden.

Aus der US 2002/0005679 A1 ist ein Schubaktuator mit einem in einer Haupterstreckungsebene verlaufenden und in dieser Haupterstreckungsebene geschlossenen, aber schubweichen Rahmen bekannt. Der Rahmen weist eine rechteckige Grundform mit zwei Paaren von parallel zueinander verlaufenden Seiten auf, die durch Festkörpergelenke untereinander verbunden sind. Zwischen den Seiten eines dieser Paare, die als Anschlusselemente des Schubaktuators dienen, und geneigt zu diesen verläuft ein Linearaktuator, insbesondere in Form eines Piezostapels. In Richtung seiner linearen Haupterstreckung bringt der Linearaktuator lokal eine Kraft, insbesondere eine Druckkraft, zwischen den beiden Seiten des Rahmens auf. Dabei verläuft der Linearaktuator auch geneigt zu den beiden anderen Seiten des Rahmens, die die Anschlusselemente des Schubaktuators als biegeweiche Stützgurte verbinden.

Aus der DE 42 20 177 A1 ist eine Vorrichtung zur Betätigung eines Ventilelements bekannt, bei der ein C-förmiger Kipphebel durch wechselweise Ansteuerung von zwei parallel zueinander angeordneten sowie einerseits an einem Arm des Betätigungshebels und andererseits an einem Abstützelement abgestützten Linearaktuatoren in einander entgegen gesetzten Richtungen verkippt wird. Dabei sind die Linearaktuatoren in Form von Piezostapeln vorgesehen, und das Abstützelement ist innerhalb des C-förmigen Kipphebels angeordnet. Auf der dem Kipphebel gegenüber liegenden Seite werden die Linearaktuatoren von einem Grundkörper, von dem das Abstützelement absteht, überspannt. Eine Vorspannkraft auf die Linearaktuatoren wird durch einen zwischen ihnen angeordneten Spannbolzen aufgebracht.

Aus der EP 1 848 046 A2 ist ein Aktuator bekannt, bei dem ein aktives Polymer in einen flexiblen Rahmen eingespannt ist. Der Rahmen umfasst sechs steife Elemente, die in Gelenken miteinander verbunden sind. Mit Hilfe des Rahmens wird eine Kontraktion des Polymers in einer Richtung in eine vergrößerte Auslenkung in eine dazu senkrechte Richtung übersetzt.

Aus der US 2003/0218403 A1 ist ein Aktuator mit den Merkmalen des Oberbegriffs des unabhängigen Patentanspruchs 1 bekannt. In einen diamant- oder rautenförmigen Rahmen ist eine elastomere dielektrische Folie zwischen zwei Elektroden eingespannt. Bei elektrischer Beaufschlagung der Folie über die Elektroden verformt sich der Rahmen, wobei die Verformung an den einander gegenüberliegenden Ecken des Rahmens abgegriffen wird, die den geringeren Abstand zueinander aufweisen. In anderen Ausführungsformen des in diesem US-Patent-Dokument beschriebenen Aktuators weist dieser einen sechs- oder achteckigen Rahmen auf. Die in der US 2003/0218403 A1 offenbarten Aktuatoren sind sämtlich Linearaktuatoren, mit denen der Abstand zwischen zwei Anschlusselementen in linearer Richtung verändert wird.

### AUFGABE DER ERFINDUNG

Der Erfindung liegt die Aufgabe zugrunde, einen Schubaktuator mit den Merkmalen der eingangs beschriebenen Art aufzuzeigen, mit dem große Verformungen realisierbar sind. Insbesondere soll der Schubaktuator zur Integration in einen Träger mit einem Steg und mit zwei durch den Steg verbundenen Gurten geeignet sein, um einen solchen Träger global zu verformen.

### LÖSUNG

Erfindungsgemäß wird die Aufgabe durch einen Schubaktuator mit den Merkmalen des unabhängigen Patentanspruchs 1 gelöst. Die abhängigen Patentansprüche 2 bis 8 betreffen bevorzugte Ausführungsformen des neuen Schubaktuators. Die abhängigen Patentansprüche 9 bis 11 betreffen den neuen Schubaktuator integrierende Träger.

### BESCHREIBUNG DER ERFINDUNG

Bei dem neuen Schubaktuator ist das aktive Flächenmaterial in einen in seiner Haupterstreckungsebene verlaufenden und in dieser Haupterstreckungsebene schubweichen Rahmen angeordnet, wobei die Verformungshauptrichtung des aktiven Flächenmaterials zu allen Seiten des Rahmens geneigt verläuft, so dass einander gegenüberliegende Seiten des Rahmens bei Ansteuerung des aktiven Flächenmaterials in seiner Verformungshauptrichtung auf Expansion oder Kontraktion gegeneinander verschoben werden. Typischerweise werden bei dem neuen Schubaktuator die einander gegenüberliegenden Seiten beider Paare von einander gegenüberliegenden Seiten des Rahmens gegeneinander verschoben. Genutzt wird bei dem neuen Schubaktuator zumindest die Relativverschiebung der beiden Seiten eines der beiden Paare. Diese einander gegenüberliegenden Seiten des Rahmens sind dabei unmittelbar die Anschlusselemente des neuen Schubaktuators oder mit passiven Strukturkomponenten verbunden.

Das bei dem neuen Schubaktuator verwendete aktive Flächenmaterial kann so konfiguriert sein, dass es in seiner Verformungshauptrichtung auf Expansion und Kontraktion angesteuert werden kann und in seiner Ebene senkrecht zur Verformungshauptrichtung gegenteilig reagiert oder gleich bleibt, d.h. bei einer Ansteuerung der Verformungshauptrichtung auf Expansion senkrecht zur Verformungshauptrichtung in seiner Ebene kontrahiert oder gleich bleibt, bei einer Ansteuerung der Verformungshauptrichtung auf Kontraktion, senkrecht zur Verformungshauptrichtung in seiner Ebene expandiert oder gleich bleibt, das heißt die Verformung durch die senkrecht zu seiner Verformungshauptrichtung entstehende Reaktion nicht wesentlich behindert, sondern wenn möglich unterstützt wird.

Konkret sind zwei einander gegenüberliegende Seiten des Rahmens als vergleichsweise steife Anschlusselemente und die beiden anderen einander gegenüberliegenden Seiten des Rahmens als in der Haupterstreckungsebene des Rahmens vergleichsweise biegeweiche Stützstege oder Stützgurte ausgebildet.

Der Rahmen weist zwei Paare von einander gegenüberliegenden und parallel zueinander verlaufenden Seiten auf. Diese Seiten sind ohne Zwischenschaltung weiterer Seiten des Rahmens miteinander verbunden. Insbesondere bevorzugt ist es dabei, dass der Rahmen eine rechteckige Grundform aufweist, aus der heraus er durch Ansteuerung des aktiven Flächenmaterials verformbar ist.

Der Rahmen, in dem das aktive Flächenmaterial angeordnet ist, dient nicht nur zur Umsetzung der Druck- und/oder Zugkräfte des aktiven Flächenmaterials in die gewünschten Schubkräfte, sondern verhindert auch, dass die Kräfte des aktiven Flächenmaterials oder äußere Kräfte auf das aktive Flächenmaterial in andere, ungewollte Verformungen resultieren.

Insbesondere wenn dieser letzte Aspekt bei größeren Rahmen nicht mehr hinreichend gewährleistet werden kann, weil innerhalb des Rahmens die Gefahr des Beulens des in seiner Verformungshauptrichtung auf Druck und/oder Zug beanspruchten aktiven Flächenmaterials besteht, kann das aktive Flächenmaterial mit innerhalb des Rahmens vorgesehenen Abstützelementen zusätzlich gegen Beulen senkrecht zu seiner Haupterstreckungsebene abgestützt sein. Vorzugsweise stützen diese Abstützelemente das aktive Flächenelement beidseitig, d. h. auf seinen beiden Hauptseiten ab.

Konkret können die Abstützelemente das aktive Flächenelement vollflächig abstützen, d. h. aus einem Bahnen- oder Plattenmaterial bestehen, das parallel zu dem aktiven Flächenmaterial und an diesem anliegend in den Rahmen eingespannt ist. Besonders bevorzugt sind für derartige flächige Abstützelemente Materialien (z.B. Sandwichkernmaterial), die eine starke Verformung in der Ebene zulassen und schubweich sind, jedoch ein Beulen der Struktur nicht zulassen.

Die Abstützelemente können alternativ oder zusätzlich den Rahmen unterteilende Stützstreben umfassen. In der Haupterstreckungsebene des Rahmens sind diese Stützstreben möglichst biegeweich, während sie normal zu der Haupterstreckungsebene des Rahmens beliebig steif sein können.

Sowohl die flächigen Abstützelemente als auch die Stützstreben können sowohl "nur" parallel zu dem aktiven Flächenmaterial angeordnet als auch fest mit diesem verbunden, beispielsweise verklebt sein.

Die Seiten des Rahmens, in dem das aktive Flächenmaterial angeordnet sind, sind notwendigerweise immer fest mit dem aktiven Flächenmaterial verbunden, so dass dieses angesichts seiner ebenen Ausrichtung in dem Rahmen als in den Rahmen eingespannt bezeichnet werden kann, auch wenn es in dem Rahmen nicht notwendigerweise unter Spannung steht.

Es können auch mehrere Lagen des aktiven Flächenmaterials parallel zueinander angeordnet werden, um die aufbringbaren Verformungskräfte zu erhöhen, wobei sich diese mehreren Lagen des aktiven Flächenmaterials direkt oder unter Zwischenordnung weiterer Abstützelemente gegenseitig abstützen können. Mit zunehmender Dicke des aktiven Flächenmaterials verringert sich bei dem neuen Schubaktuator die Beulgefahr des aktiven Flächenmaterials unter Belastung, womit sich zusätzliche Abstützelemente erübrigen können.

Weiterhin ist es möglich, dass mehrere Rahmen desselben oder benachbarter erfindungsgemäßer Schubaktuatoren, in denen das aktive Flächenmaterial angeordnet ist, so nebeneinander angeordnet sind, dass mindestens zwei Seiten von zwei einander benachbarten Rahmen durch dasselbe Bauelement ausgebildet sind. Zwischen verschiedenen Aktuatoren kann dann unterschieden werden, wenn das aktive Flächenmaterial eines von ihnen unabhängig von dem aktiven Flächenmaterial der anderen Aktuatoren angesteuert werden kann. Darüber hinaus ist das Einbetten eines Sensors für eine Schubüberwachung unmittelbar in das aktive Flächenmaterial (siehe die kommerziellen Produkte der Firma Smart Material GmbH (www.smart-material.com)) oder auch einen das aktive Flächenmaterial und Abstützelemente umfassenden Sandwichaufbau möglich.

In einer besonders bevorzugten konkreten Ausführungsform des neuen Schubaktuators sind zwei einander gegenüberliegende Seiten des Rahmens mit sich längs der Seiten erstreckenden und senkrecht zu der Haupterstreckungsebene des Rahmens ausgerichteten Gurten verbunden, die sich bei der erfindungsgemäßen Ansteuerung des erfindungsgemäßen Schubaktuators gegeneinander verschieben. Wenn die Enden der Gurte an einem Ende dieser Struktur relativ zueinander fixiert sind, so dass dort keine Relatiwerschiebung der Gurte möglich ist, resultiert hieraus eine Verbiegung des Trägers, der durch die beiden Gurte und den sie verbindenden Schubaktuator ausgebildet wird.

Ein erfindungsgemäßer Träger weist entsprechend einen mindestens einen erfindungsgemäßen Schubaktuator aufweisenden Steg und zwei durch den Steg miteinander verbundenen Gurte auf. Dabei kann ein solcher Träger insbesondere ein Doppel-T-Träger oder ein U-Träger sein.

Die genaue Orientierung der Verformungshauptrichtung des aktiven Flächenmaterials zu den Seiten des Rahmens kann innerhalb des Patentanspruchs 1 grundsätzlich frei gewählt und an die Bedürfnisse des konkreten Anwendungsfalls des neuen Schubaktuators angepasst werden.

Bei einem erfindungsgemäßen neuen Träger kommt ein Ansatz einer aktiven integrierten Strukturkomponente zur Anwendung. Dabei wird eine passive Strukturkomponente durch eine gerichtete aktive Strukturkomponente ersetzt und an Stellen eingebracht, an denen die zu übernehmenden Lasten gleichmäßig verteilt und über definierte Bereiche als nahezu konstant erachtet werden können. Diese Anforderungen sind bei dem Steg eines Trägers, soweit dieser gegenüber den beiderseits angebrachten Gurten als schlank definiert werden kann, in besonders guter Weise erfüllt. Entsprechend lässt sich eine aktive Komponente in die Struktur eines solchen Trägers einbringen und wird dabei von einer nahezu konstant wirkenden Kraft-Spannungsverteilung beaufschlagt. Durch die Einbettung in einem Rahmen wird die aktive Komponente in Form des aktiven Flächenmaterials nicht direkt mit dem Krafteinleitungspunkt der Struktur in Verbindung gebracht, wodurch auftretende Spannungspitzen nicht auf die aktive Komponente übertragen werden. Bei der resultierenden nahezu gleichmäßigen Spannungsverteilung lässt sich die Aktuatorik zielgerichteter auslegen und in die Struktur integrieren. Die mit der aktiven Komponente erzielbare freie Dehnung lässt sich abgesehen von der Ausführung und der resultierenden Steifigkeit des Rahmens nahezu komplett auf die Gesamtstruktur übertragen. Die von der Aktuatorik aufzubringende Verformungsenergie, um die passive Rahmenstruktur zu verformen, ist je nach Größe und Richtung der Verformung nur klein. Durch diese Konfiguration wird der überwiegende Anteil an aktiver Strukturenergie an die zu verschiebende Last weitergegeben.

Bei der Auslegung der Aktuatorik müssen die möglicherweise auftretenden Belastungen bewertet werden. Wird mehr als nur ein flächiger Aktuator, d. h. mehr als eine Lage des aktiven Flächenmaterials mit definierter Dicke benötigt, so lässt der erfindungsgemäße Aufbau mehrere planparallele Lagen des aktiven Flächenmaterials zu. Zu beachten ist dabei immer, dass ein Beulen des aktiven Flächenmaterials auch unter maximaler Belastung möglichst verhindert wird. Hierzu sind die bereits angesprochenen Abstützelemente in der notwendigen Stärke und Dichte vorzusehen.

Das Einspannen des aktiven Flächenmaterials in den Rahmen kann durch Formschluss, so auch durch Einschrauben, Kraftschluss, insbesondere Festklemmen, und Einkleben bewirkt werden. Vorzugsweise ist der Rahmen dabei auf beiden Seiten des aktiven Flächenmaterials vorgesehen.

Durch die Möglichkeit, die Verformungshauptrichtung des aktiven Flächenmaterials relativ zu den Haupterstreckungsrichtungen der bei einem erfindungsgemäßen Träger daran angrenzenden Gurte zu variieren, kann eine Anpassung an die im Einzelfall auftretenden Belastungsrichtungen erfolgen. Dabei ist insbesondere die Richtung zu berücksichtigen, in die auf die Gesamtstruktur einwirkenden Querkräfte über die Gurte auf den Steg des erfindungsgemäßen Trägers umgelenkt werden.

Der Rahmen für das aktive Flächenmaterial bei dem erfindungsgemäßen Schubaktuator bzw. dem erfindungsgemäßen Träger kann einschließlich der Abstützelemente in Faserverbundtechnologie ausgebildet sein, um die gewünschte Steifigkeitsverteilung mit geringem Aufwand und mit geringem Leistungsgewicht zu erreichen. Der Rahmen kann aber z. B. auch aus Leichtmetallen ausgebildet sein.

Die möglichen Einsatzgebiete für den neuen Schubaktuator bzw. den neuen Träger sind mannigfaltig. Sie umfassen die beiden Hauptgruppen, in denen einerseits ein bestimmter Punkt einer Struktur ruhig, d. h. schwingungsfrei und/oder sich unter Last nicht verschiebend, gehalten wird und andererseits ein bestimmter Punkt einer Struktur definiert gegenüber einem bestimmten anderen Punkt der Struktur positioniert. D. h. verschoben wird. Dabei gibt es natürlich auch Anwendungen, die zu beiden Gruppen zu zählen sind. Konkrete Anwendungsfälle sind flexible Tragflächenkonfigurationen bei Fluggeräten, adaptive Getränkehalterungen in Kraftfahrzeugen, Präzisionspositioniereinheiten in Fertigungsmaschinen, aktive Schwingungsunterdrückung und (mit umgekehrter Zielrichtung) Rüttelmechanismen.

Vorteilhafte Weiterbildungen der Erfindung ergeben sich aus den Patentansprüchen, der Beschreibung und den Zeichnungen. Die in der Beschreibungseinleitung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

### KURZBESCHREIBUNG DER FIGUREN

Die Erfindung wird im Folgenden anhand konkreter Ausführungsbeispiele unter Bezugnahme auf die beigefügten Zeichnungen näher erläutert und beschrieben.
- **Fig. 1**: zeigt ein Querschnittsprofil eines Doppel-T-Trägers.
- **Fig. 2**: zeigt ein Querschnittsprofil eines U-Trägers.
- **Fig. 3**: zeigt eine Seitenansicht eines Trägers, in dessen Steg ein aktives Flächen- material integriert ist.
- **Fig. 4**: ist eine Explosionszeichnung eines das aktive Flächenmaterial bei der Integration gemäß Fig. 3 aufnehmenden Rahmens.
- **Fig. 5**: zeigt das in den zusammen gebauten Rahmen gemäß Fig. 4 eingespannte aktive Flächenmaterial.
- **Fig. 6**: ist eine Explosionszeichnung einer alternativen Ausführungsform des Rahmens gemäß Fig. 4.
- **Fig. 7**: zeigt das in den zusammen gebauten Rahmen gemäß Fig. 6 eingespannte aktive Flächenmaterial.
- **Fig. 8**: stellt das Wirkprinzip des aktiven Flächenmaterials mit diagonal über seine Haupterstreckungsebene verlaufender Verformungshauptrichtung unter Querlast- beaufschlagung dar, bei der es sich um die aktive Wirkrichtungen des erfin- dungsgemäßen Schubaktuators handelt.
- **Fig. 9**: ist eine Explosionszeichnung eines auf dem aktiven Flächenmaterial aufbau- enden Schubaktuators.
- **Fig. 10**: ist eine Explosionszeichnung eines Schubaktuators mit zwei Lagen des aktiven Flächenmaterials.
- **Fig. 11**: ist eine Explosionszeichnung einer weiteren Ausführungsform des Schubaktu- ators mit zwei Lagen des aktiven Flächenmaterials.
- **Fig. 12**: ist eine Explosionszeichnung noch einer weiteren Ausführungsform des Schub- aktuators mit zwei Lagen des aktiven Flächenmaterials.
- **Fig. 13**: ist eine Explosionszeichnung eines Schubaktuators mit drei Lagen des aktiven Flächenmaterials.
- **Fig. 14**: zeigt einen zusammengebauten Schubaktuator gemäß Fig. 13 mit zwei Lagen des aktiven Flächenmaterials.
- **Fig. 15**: zeigt ein Element eines Schubaktuators mit einem in einen Rahmen einge- spannten aktiven Flächenelement; und die
- **Fig. 16 und 17**: zeigen Aufbauten aus mehreren Elementen gemäß Fig. 15.

### FIGURENBESCHREIBUNG

Das bei der vorliegenden Erfindung eingesetzte Flächenmaterial ist kommerziell von der Firma Smart Material GmbH (www.smart-material.com) als "d33 Actuator with Twisting Motion (F1)" in verschiedenen Ausführungsformen erhältlich. Die vorliegende Erfindung ist aber nicht an die Verwendung genau dieses auf einem d33-Effekt piezoelektrischer Fasern basierenden aktiven Flächenmaterials gebunden. Insbesondere bezüglich der Richtung, d. h. des Winkels des Verlaufs der einzelnen piezo-keramischen Fasern zu den Kanten des aktiven Flächenmaterials kann es interessant sein, von den kommerziell verfügbaren Standardprodukten abzuweichen.

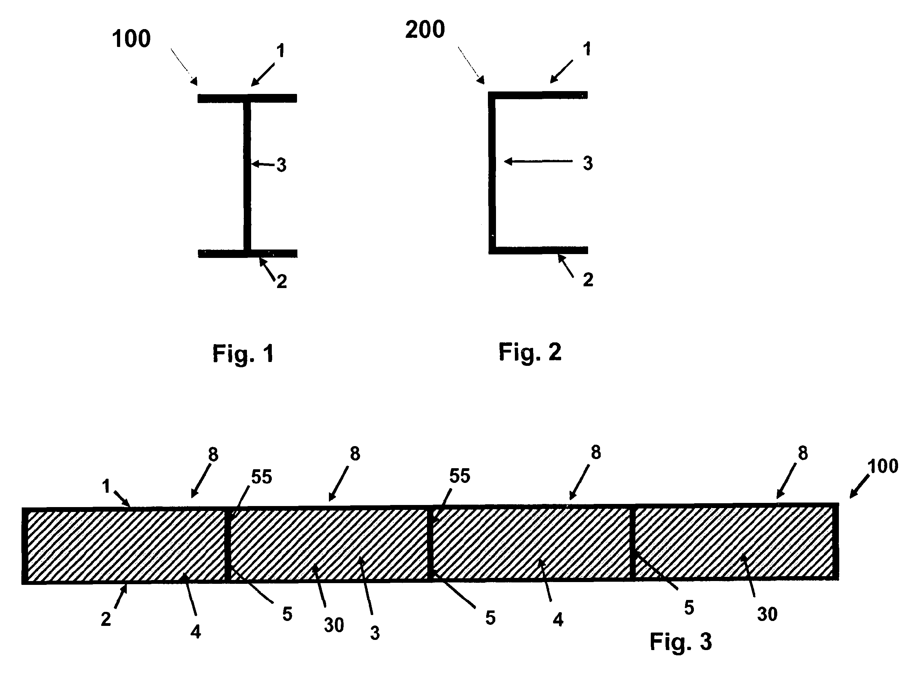

**Fig. 1** zeigt einen Querschnitt durch einen Doppel-T-Träger 100. Der Doppel-T-Träger 100 weist einen Obergurt 1 und einen Untergurt 2 auf, die durch einen Steg 3 miteinander verbunden sind. Alle Teile 1 bis 3 des Doppel-T-Trägers 100 weisen jeweils eine im Wesentlichen zweidimensionale Erstreckung auf, die einmal in der Querschnittsebene gemäß Fig. 1, d. h. deren Zeichenebene und einmal senkrecht dazu verläuft. Zwischen den Teilen 1 bis 3 des Doppel-T-Trägers sind dabei Festkörperverbindungen vorgesehen, d. h. die Verbindungen zwischen den Teilen 1 bis 3 sind nicht weniger steif als die Teile 1 bis 3 selbst.

**Fig. 2** zeigt einen Querschnitt durch einen U-Träger 200. Auch bei diesem sind ein Obergurt 1 und ein Untergurt 2 durch einen Steg 3 miteinander verbunden. Während jedoch bei dem Doppel-T-Träger 100 gemäß Fig. 1 der Steg 3 mittig an den Obergurt 1 und den Untergurt 2 angesetzt ist, liegen diese Ansatzpunkte bei dem U-Träger gemäß **Fig. 2** an einander entsprechenden seitlichen Enden des Obergurts 1 und des Untergurts 2. Ansonsten treffen alle Angaben zu dem Doppel-T-Träger 100 gemäß Fig. 1 auch auf den U-Träger 200 gemäß Fig. 2 zu.

Der bei herkömmlichen Doppel-T-Trägern 100 gemäß Fig. 1 und U-Trägern 200 gemäß Fig. 2 rein passive Steg 3 ist bei einem erfindungsgemäßen Träger durch einen Steg 3 ersetzt, der ganz oder teilweise aktiv, d. h. auf Formveränderungen ansteuerbar ist. Ein Beispiel für einen solchen aktiven Steg zeigt **Fig. 3** in einer Seitenansicht auf den Doppel-T-Träger 100 gemäß Fig. 2, wobei der U-Träger gemäß Fig. 2 in einer entsprechenden Seitenansicht genauso aussehen könnte. Wie auch bei bestimmten passiven Trägern sind Stegbegrenzungen 55 vorgesehen, um den Steg 3 in mehrere Stegfelder 30 zu unterteilen. Dies ist bei Leichtbaustrukturen notwendig, um die Gefahr eines Beulens des Stegs zu verringern. Bei dem dargestellten aktiven Steg 3 ist jedes Stegfeld 30 als Rahmen 8 ausgeführt, in den ein aktives Flächenmaterial 4 eingespannt ist. Die Rahmen 8 sind an den Stegbegrenzungen 55 bzw. über den Obergurt 1 und den Untergurt 2 miteinander verbunden. Die Stegbegrenzungen 55 sind als Stützstege 5 ausgebildet, die den Obergurt 1 und den Untergurt 2 auf Abstand halten, aber selbst und/oder bezüglich der Anbindung an den Obergurt 1 und den Untergurt 2 in der Haupterstreckungsebene des Stegs 3 biegeweich sind. Senkrecht zu dieser Haupterstreckungsebene des Stegs 3 können die Stützstege 5 hingegen beliebig steif sein. Beide Maßnahmen wirken einem Beulen des Stegs 3 einschließlich des aktiven Flächenmaterials entgegen. Das in die Rahmen 8 eingespannte aktive Flächenmaterial 4 weist eine diagonal verlaufende, d. h. zu allen Seiten der Rahmen 8 unter einem Winkel ausgerichtete Verformungshauptrichtung auf, was durch eine Diagonalschraffur im Bereich des aktiven Flächenmaterials 4 angedeutet ist. Durch Ansteuerung des aktiven Flächenmaterials 4 auf eine Längenänderung in seiner Verformungshauptrichtung wird eine Schubkraft zwischen dem Obergurt 1 und dem Untergurt 2 ausgeübt. Diese führt bei einseitiger Einspannung des Obergurts 1 und des Untergurts 2 zu einer aktiven Verbiegung des Doppel-T-Trägers 100 in der Zeichenebene nach oben oder nach unten, wobei die Amplitude der Auslenkung von der Anzahl der Rahmen 8 abhängig ist. Die Schubkraft zwischen dem Obergurt 1 und dem Untergurt 2 führt zu einer Parallelverschiebung des Obergurts 1 und des Untergurts 2 in entgegen gesetzter Richtung, welche zu dem Auslenken der Doppel-T-Trägers 100 bzw U-Trägers 200 führt. Die Schubkraft kann alternativ zum Geradehalten des Doppel-T-Trägers 100 bei auftretenden äußeren Lasten oder zur aktiven Schwingungsdämpfung des Doppel-T-Trägers 100 genutzt werden.

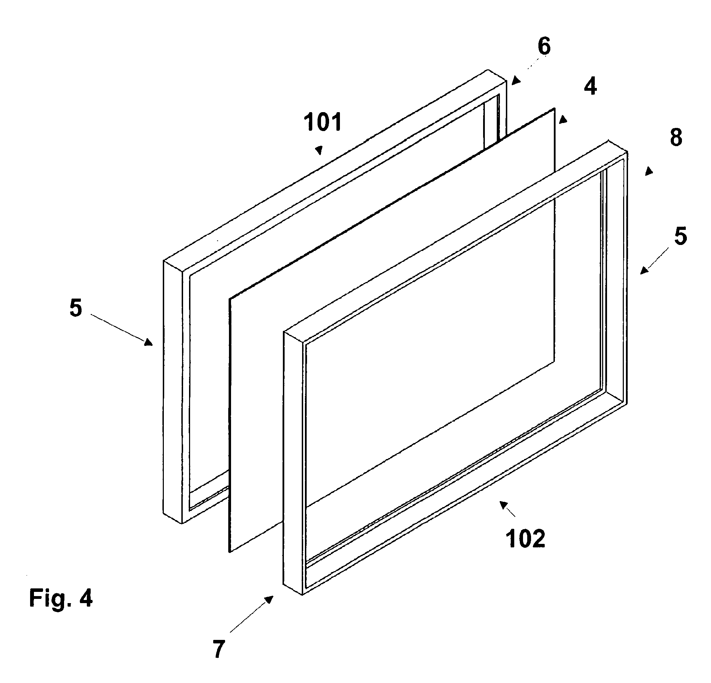

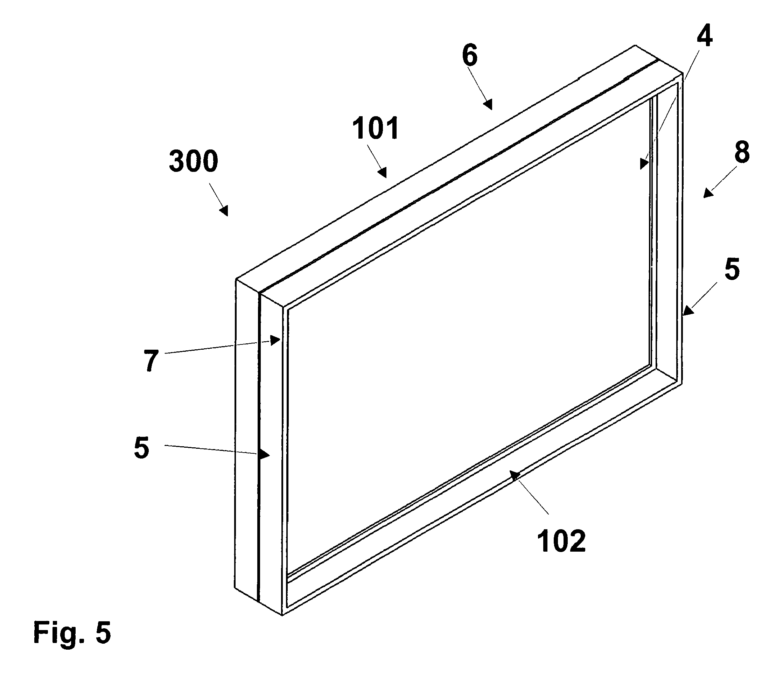

**Fig. 4** zeigt einen einzelnen Rahmen 8 zusammen mit dem zugehörigen aktiven Flächenmaterial 4 in einer Explosionszeichnung. Der Rahmen 8 besteht aus zwei Halbschalen 6 und 7, die unter Zwischenordnung des Rands des aktiven Flächenmaterials 4 miteinander verklebt werden. Der Rahmen 8 bildet die Stützstege 5 aus, und er kann auch unmittelbar den Obergurt 1 und den Untergurt 2 ausbilden. Gezeigt ist hier jedoch, dass der Rahmen Anschlusselemente 101 und 102 zum Anschluss des Rahmens 8 an den Obergurt 1 und den Untergurt 2 ausbildet. Der zusammengebaute Rahmen 8 gemäß Fig. 4 ist in **Fig. 5** gezeigt.

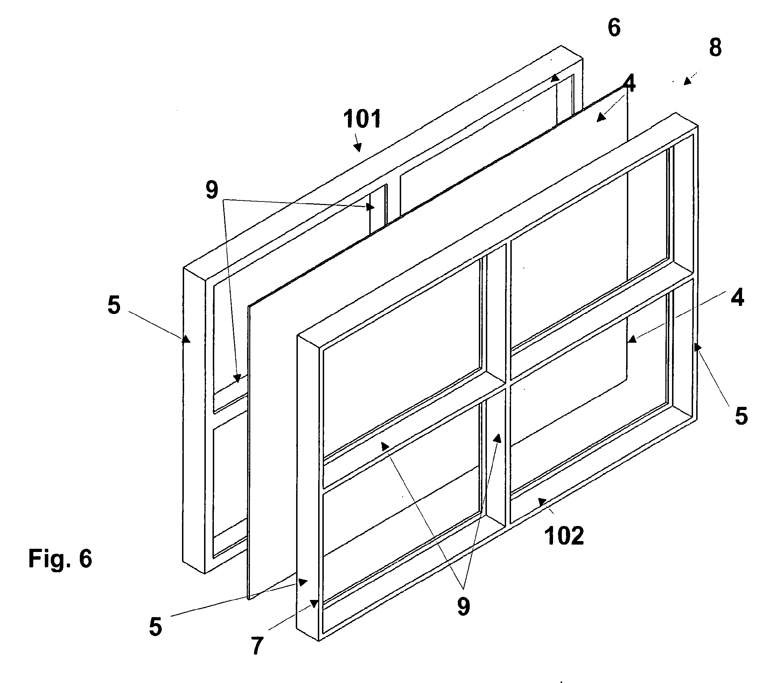

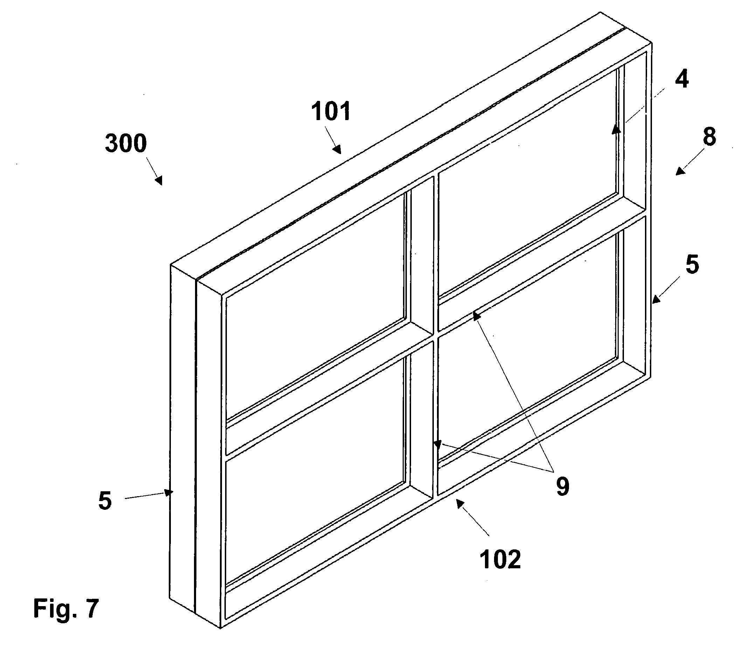

**Fig. 6** zeigt eine Explosionszeichnung einer alternativen Ausführungsform des Rahmens 8, bei der der Rahmen 8 zusätzliche Stützstreben 9 aufweist, die den Rahmen 8 einerseits parallel zu den Stützstegen 5 und andererseits parallel zu den Anschlusselementen 101 und 102, d. h. den hier nicht dargestellten Gurten 1 und 2, unterteilen. Die Stützstreben 9 sorgen faktisch für eine Verkleinerung der Abmessungen des Rahmens 8 und damit für eine bessere Abstützung des aktiven Flächenmaterials 4, um dieses in der Haupterstreckungsebene des Rahmens 8 zu halten. Hiermit wird insbesondere ein Beulen, d. h. eine Auslenkung des aktiven Flächenmaterials 4 senkrecht zu der Haupterstreckungsebene des Rahmens 8, bei Ansteuerung des aktiven Flächenmaterials 4 auf eine Längenänderung in seiner Verformungshauptrichtung oder aufgrund externer Lasten verhindert. Ein derartiges Beulen oder Ausknicken resultiert in eine undefinierte Relativbeziehung zwischen der Ansteuerung des aktiven Flächenmaterials 4 und dem zwischen den Anschlusselementen 101 und 102 aufgebrachten Schub bzw. der hieraus resultierenden Parallelverschiebung. Die Stützstreben 9 sind vorzugsweise wie die Anschlusselemente 101 und 102 sowie die Stützstege 5 fest mit dem aktiven Flächenmaterial 4 verklebt. Die parallel zu den Stützstegen 5 verlaufenden Stützstreben 9 weisen vorzugsweise deren bevorzugte Eigenschaften auf. Entsprechend weisen die parallel zu den Anschlusselementen 101 und 102 und den hier nicht dargestellten Gurten 1 und 2 verlaufenden Stützstreben 9 vorzugsweise deren bevorzugte Eigenschaften auf. Die eingebrachten Stützstreben 9 sind in ihren Abmessungen so auszulegen, dass sie ein Beulen des aktiven Flächenmaterials 4 verhindern. Zur Vereinfachung können sie die gleichen Eigenschaften und Abmessungen aufweisen wie die Anschlusselemente 101 und 102 bzw. die hier nicht dargestellten Gurte 1 und 2 sowie die seitlichen Stützstege 5. **Fig. 7** zeigt den zusammengebauten Rahmen 8 gemäß Fig. 6 mit dem darin eingespannten Flächenmaterial 4.

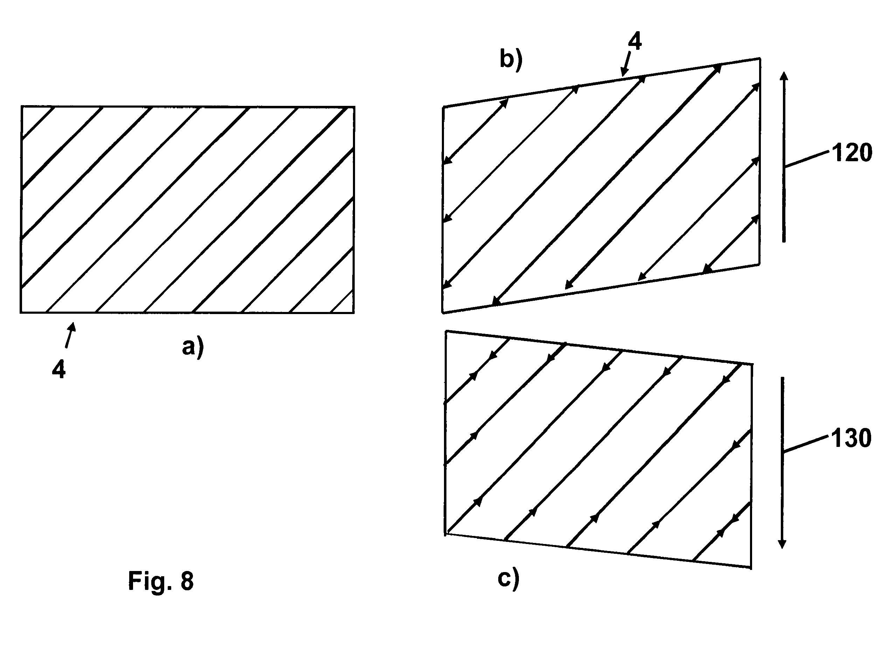

**Fig. 8** zeigt einen Abschnitt des aktiven Flächenmaterials 4 bei unterschiedlichen Schubbelastungen (a bis c). Dabei ist die diagonal zu den Kanten des Abschnitts verlaufende Verformungshauptrichtung des aktiven Flächenmaterials 4 wieder durch eine Diagonalschraffur angedeutet. Bei einer Aktivierung des aktiven Flächenmaterials 4 in seiner Verformungshauptrichtung auf eine Expansion, d. h. auf Verlängerung oder auf Druck hin ergibt sich gegenüber der rechteckigen, nicht angesteuerten oder belasteten Ausgangsform gemäß **Fig. 8a****)** die in **Fig. 8b****)** gezeigte Schubverformung, bei der sich die rechte Seite des aktiven Flächenmaterials 4 gegenüber seiner linken Seite in Richtung eines Pfeils 120 verschiebt. Aus einer Aktivierung des aktiven Flächenmaterials 4 in seiner Verformungshauptrichtung auf eine Kontraktion, d. h. auf Verkürzung oder Zug hin resultiert hingegen die Schubverformung gemäß **Fig. 8c****),** in der sich die rechte Seite in Richtung eines zu dem Pfeiler 120 entgegen gesetzten Pfeils 130 gegenüber der linken Seite bewegt. Bei einer passiven Verformung des aktiven Flächenmaterials in Richtung der Pfeile 120 und 130 treten entsprechende Zug- bzw. Druckbelastungen im Bereich des aktiven Flächenmaterials 4 als reactio auf. Diese Belastungen sind, wenn das aktive Flächenmaterial 4 in dem Steg eines Trägers mit Obergurt und Untergurt eingesetzt wird, über die Fläche des Stegs bzw. des aktiven Flächenelements nahezu homogen verteilt, woraus eine Gleichbeanspruchung des gesamten aktiven Materials 4 resultiert. Dies stellt einen Idealfall für den Einsatz aktiver Materialien dar.

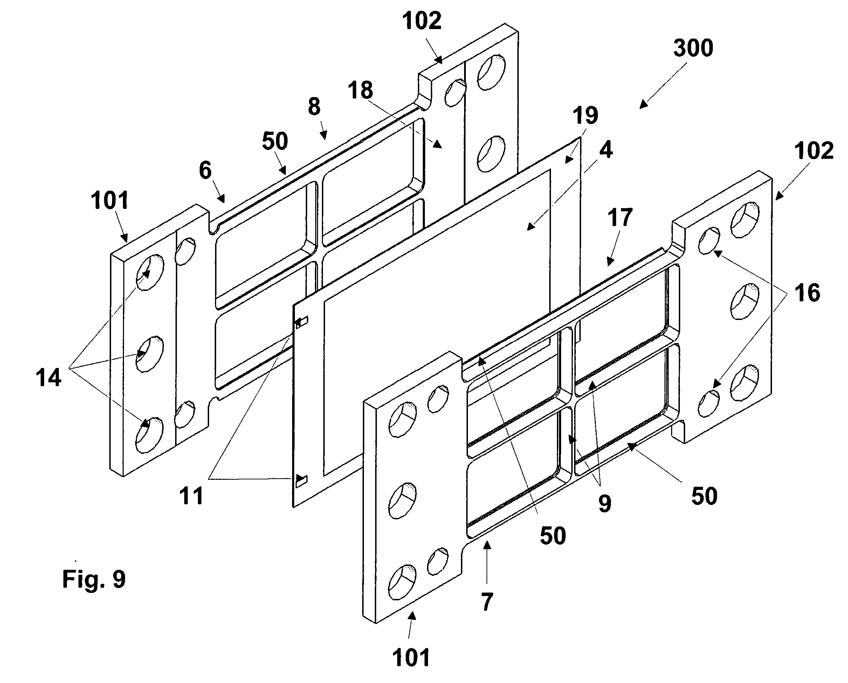

Neben seiner Verwendung als Schubaktuator im Bereich des Stegs eines Trägers mit Steg und Obergurt und Untergurt kann das in einen Rahmen 8 eingespannte aktive Flächenmaterial 4 auch als isolierter Schubaktuator 300 Verwendung finden. **Fig. 9** zeigt eine Explosionszeichnung eines derartigen Schubaktuator 300, dessen integrierter Rahmen 8 dem Rahmen 8 gemäß den voranstehenden Fig. 6 und 7 entspricht. Der Rahmen 8 wird durch die hier seitlich liegenden Anschlusselemente 101 und 102 und durch diese miteinander verbindende Stützgurte 50 ausgebildet. In dem Rahmen sind parallel zu den Anschlusselementen und den Stützgurten verlaufende Stützstreben 9 zur Abstützung des aktiven Flächenmaterials 4 vorgesehen. Die Anschlusselemente 101 und 102 sind im Bereich beider Halbschalen 6 und 7 des Rahmens 8 mit Befestigungsbohrungen 14 versehen. Weitere Bohrungen 16 in den Anschlusselementen 101 und 102 dienen zur Kontaktierung von Anschlusskontakten 11 von Elektrodenanordnungen des aktiven Flächenmaterials 4 und können nach erfolgter Kontaktierung mit elektrisch isolierendem Material vergossen werden. Dies ist insbesondere dann vorteilhaft, wenn die Halbschalen 6 und 7 des Rahmens 8 aus einem elektrisch leitfähigen Material bestehen. An den Stützstegen 8 und den Abstützelementen 9 vorgesehene Absätze 17 vergrößern die Kontaktfläche zu dem aktiven Flächenmaterial 4, das in allen Kontaktbereichen mit dem Rahmen 8 verklebt ist und dabei in einer Tasche 18 des Rahmens 8 angeordnet ist. Die piezokeramischen Fasern des aktiven Flächenmaterials 4 können in eine Matrix 19 eingebettet sein, die sich über den eigentlichen aktiven Bereich des aktiven Flächenmaterials 4 hinaus erstreckt und dort durch Form- oder Kraftschluss wie z.B. Einklemmen oder Einkleben in den Rahmen montiert ist.

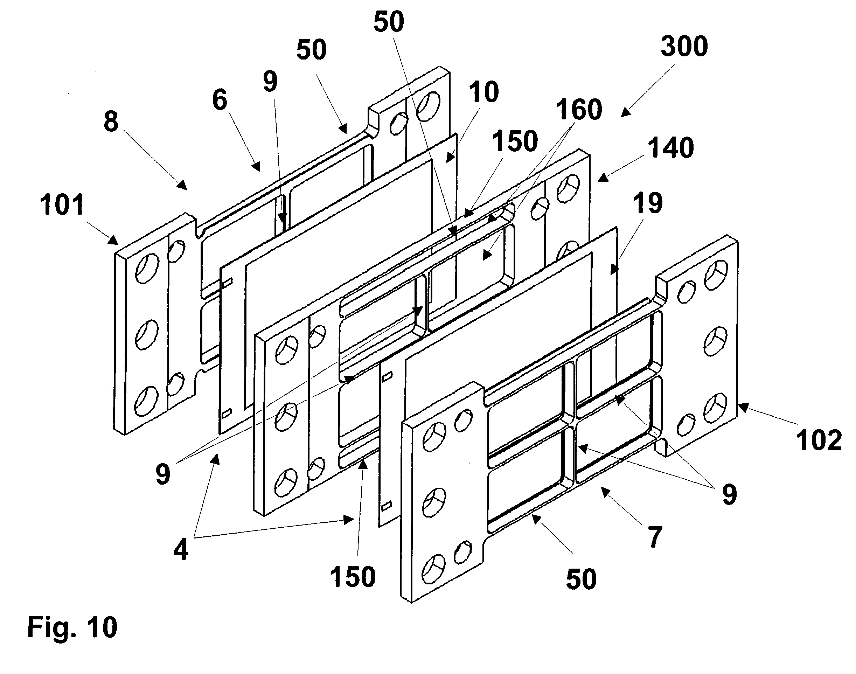

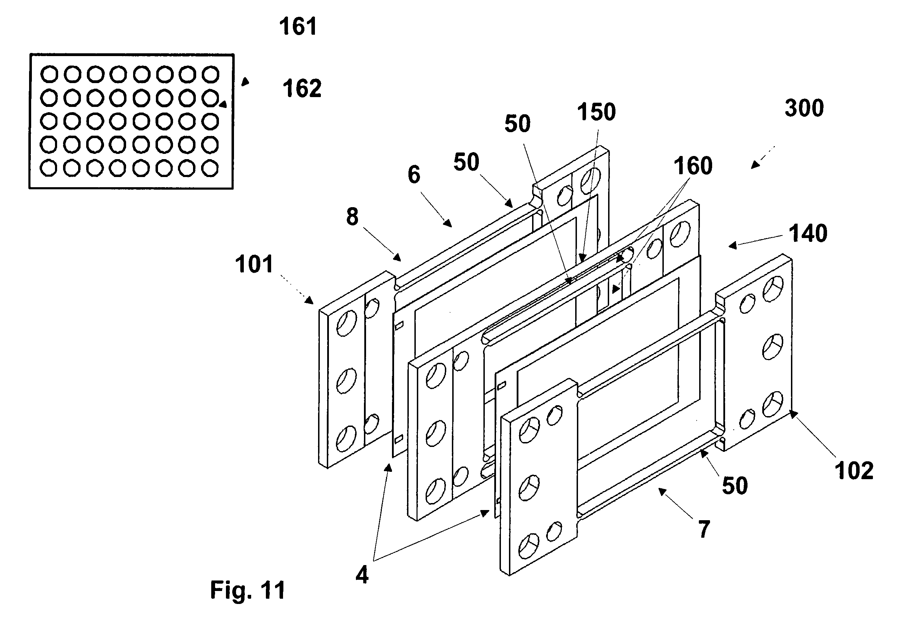

Der Schubaktuator 300 gemäß **Fig. 10** weist nicht nur einen Abschnitt des aktiven Flächenmaterials 4 wie der Schubaktuator gemäß Fig. 9 sondern zwei planparallel zueinander angeordnete Abschnitte des aktiven Flächenmaterials 4 und ein dazwischen angeordnetes Zwischenelement 140 des Rahmens 8 auf, das beim Zusammenbau des Schubaktuators 300 mit beiden Abschnitten des aktiven Flächenmaterials 4 verklebt wird. Dieses Zwischenelement 140 weist zusätzliche Stützgurte 150 auf, die ebenfalls mit den Abschnitten des aktiven Flächenmaterials 4 bzw. dessen Matrix 19 verklebt sein können. Die Stützgurte 150 dienen dazu, das aus einer Verschiebung der Anschlusselemente 101 und 102 gegeneinander resultierende Biegemoment unterstützend zu den Stützgurten 50 und den parallel dazu verlaufenden Stützstreben 9 abzustützen. Alle Hohlräume 160 im Bereich des Zwischenelements 140 des Rahmens 8 können, sofern es die Belastung erfordert, bei dem fertigen Schubaktuator 300 mit einem Sandwichmaterial oder einem in den Fig. 11 bis 13 separat dargestellten anderen flächigen oder mit äquivalenten Innenstrukturmusterungen 162 versehenen Füllelement 161 ausgefüllt sein.

Der Schubaktuator 300 gemäß **Fig. 11** unterscheidet sich von demjenigen gemäß Fig. 10 durch Weglassen der Stützstreben 9 bei den Halbschalen 6 und 7 und dem Zwischenelement 140 des Rahmens 8. Auch hierbei können die Hohlräume 160 im Bereich des Zwischenelements 140 bei dem montierten Schubaktuator mit Sandwichmaterial aufgefüllt sein, um zumindest ein Abstützelement für das seitliche Abstützen des aktiven Flächenmaterials bereitzustellen und Beulen zu vermeiden.

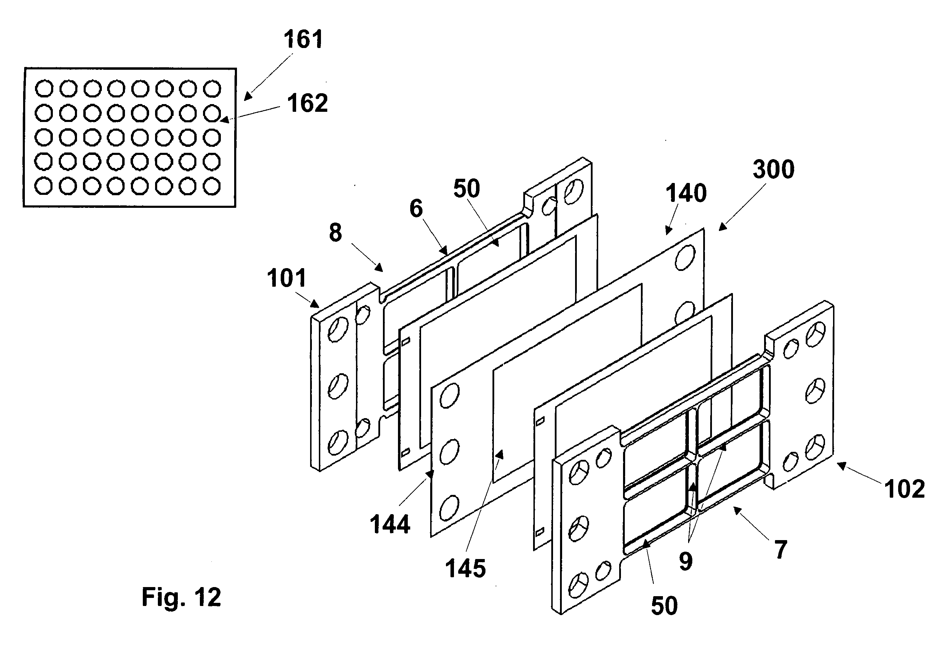

Bei dem Schubaktuator 300 gemäß **Fig. 12** ist das Zwischenelement 140 des Rahmens 8 abweichend von Fig. 10 nicht skelettiert, sondern als flächiges und zu dessen Abstützung flächig mit dem aktiven Flächenmaterial 4 verklebtes CFK-Bauteil ausgebildet, das innerhalb eines Zwischenrahmens 144 eine weiche Innenstruktur 145 aufweist. Dabei fällt der Zwischenrahmen 144 im Wesentlichen mit den Anschlusselementen 101 und 102 sowie den Stützstreben 5 der Halbschalen 6 und 7 zusammen, während die weiche Innenstruktur 145 in dem freien Querschnittsbereich des Rahmens 8 (und dort zum Teil unterhalb der Abstützelemente 9) liegt. Die Innenstruktur 145 dient dabei zum Dickenausgleich bezüglich des Zwischenrahmens 140. Die weiche Innenstruktur 145 kann flächig ausgeführt sein, aber auch eine Innenstrukturmusterung 162 aufweisen, die die passive Klebeschichtfläche verringert und neben dem Dickenausgleich auch die Beulgefahr der aktiven Flächenmaterialien minimiert. Die Innenstrukturmusterung 162 kann wie dargestellt ein Lochmuster oder auch eckige Strukturen zur Reduzierung der passiven Klebefläche aufweisen. Die Innenstrukturmusterung 162 kann gleichmäßig verteilt oder versetzt angeordnet sein. Sollte die Gesamtdicke aus aktivem Flächenmaterial 4 und dem Zwischenrahmen 144 mit weicher Innenstruktur 145 ausreichend sein, so können die Abstützelemente 9 entfallen. Die Gesamtdicke ermittelt sich aus der Anzahl der verwendeten und für die Last notwendigen aktiven Flächenmaterialien 4 und den für die Lastübertragung und Lastübergängen notwendigen Zwischenrahmen 144 sowie der weichen Innenstruktur 145. Bei dem Schubaktuator 300 gemäß Fig. 12 können auch die Halteschalen 6 und 7 in CFK-Technik ausgebildet sein. Grundsätzlich können für den Rahmen 8 aber verschiedenste Materialen Verwendung finden.

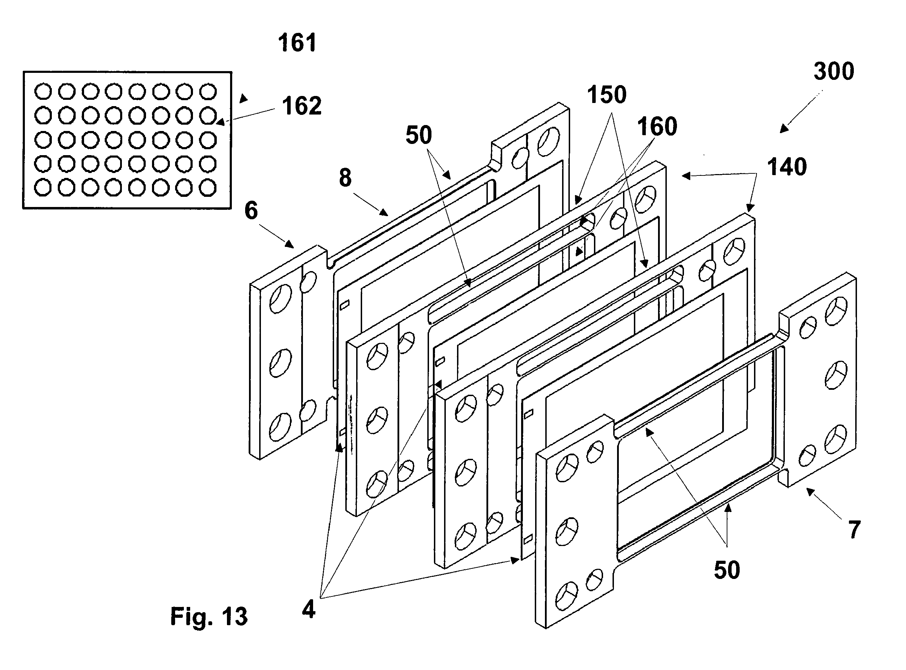

**Fig. 13** skizziert einen Schubaktuator 300 mit drei parallel zueinander angeordneten Abschnitten des aktiven Flächenmaterials 4, wobei der Rahmen 8 neben den äußeren Halbschalen 6 und 7 zwei Zwischenelemente 140 aufweist. Auch hier kann die Anzahl der Lagen des aktiven Flächenmaterials 4 und der Zwischenelemente 140 mit deren gegen Beulen mit Füllelementen 161 aus Sandwichmaterial oder anderen ungemusterten oder gemusterten Materialien ausgefüllten Hohlräumen 160 variiert werden. Das die Hohlräume füllende Material muss nicht den gesamten Innenraum flächig einnehmen, sondern kann wiederum eine Innenstrukturmusterung 162 aufweisen, die so ausgelegt ist, dass das belastete aktive Flächenmaterial 4 nicht beult. Ziel ist es, die flächige Klebefläche zwischen dem aktiven Flächenmaterial 4 und dem das Beulen verhindernden Füllelement 161 so klein wie möglich zu halten, um die aufzubringenden Energien zum Verformen eben dieser passiven Klebefläche und des Füllelements 161 so gering wie möglich zu halten. Hierzu kann ein Lochmuster wie bei der Innenstrukturmusterung 162 dargestellt verwendet werden oder auch anderweitige Innenstrukturmusterungen mit eckigen Aussparungen. Die Innenstrukturmusterung 162 kann gleichmäßig verteilt sein oder versetzt angeordnet sein.

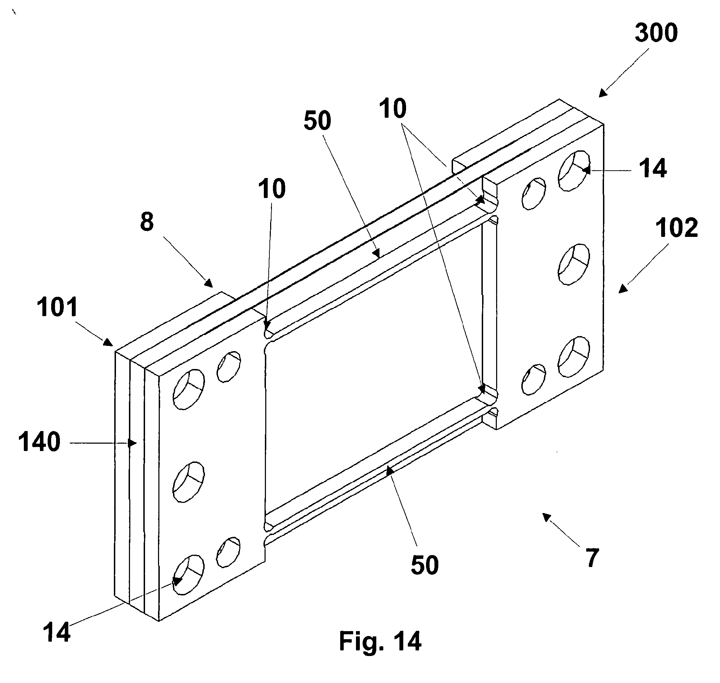

In **Fig. 14** ist ein gleichartiger paketförmiger Schubaktuator 300 in zusammengebautem Zustand gezeigt. Das Zwischenelement 140 sowie die Halbschalen 6 und 7 des Rahmens 8 können wie bereits zu Fig. 12 ausgeführt in Faserverbundtechnologie oder aus anderen Werkstoffen gefertigt sein. Die Stützgurte sind über in der Haupterstreckungsebene des Rahmens 8 biegeweiche Festkörpergelenke 10 an die Anschlusselemente 101 und 102 angebunden.

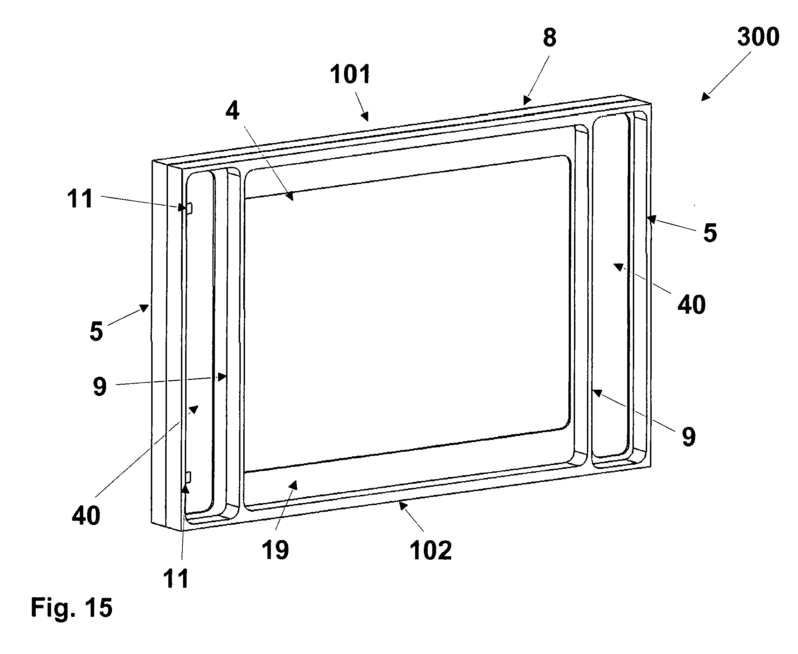

**Fig. 15** zeigt einen Schubaktuator 300, der denjenigen gemäß den Fig. 13 und 14 im Wesentlichen entspricht, außer dass die Anschlusselemente 101 und 102 hier weniger massiv ausgebildet sind und beispielsweise keine Befestigungslöcher 14 aufweisen. So sind wieder die Anschlusselemete 101 und 102 als Gurte ausgelegt bzw. zum Anschluss an solche Gurte vorgesehen; und in dieser Form kann der Schubaktuator 300 in einem Balken 100 oder 200 gemäß den Fig. 1 bis 3 integriert werden. Dabei sind mit Hilfe von Stützstreben 9, die parallel zu den Stützstegen 5 verlaufen, Randbereiche 40 des aktiven Flächenmaterials 4 abgetrennt, um dessen Anschlusskontakte 11 offen zu lassen. Diese Konfiguration der Schubaktutoren 300 basiert auf den derzeit erhältlichen aktiven Flächenmaterialien 4. Sind andere aktive Flächenmaterialen mit anderer Konfigurationen erhältlich, können beispielsweise die Nebenbereiche 40, die hauptsächlich notwendig sind, um die derzeitigen Anschlusskontakte 11 offen zu lassen, entfallen. Bei einer speziell angefertigten Konfiguration kann das aktive Flächematerial 4 auch die gesamte Höhe und Breite des Rahmens 8 einnehmen oder sich auch über mehrere Rahmen 8 hinweg erstrecken. In dieser Form können die einzelnen Schubaktuatoren 300 zu einem Schubaktuator mit mehreren Feldern zusammengefasst werden, wie die Konfiguration in Fig. 3 zeigt, und zur Ausbildung des Stegs 3 eins Doppel-T-Trägers 100 oder eines U-Trägers 200 verwendet werden.

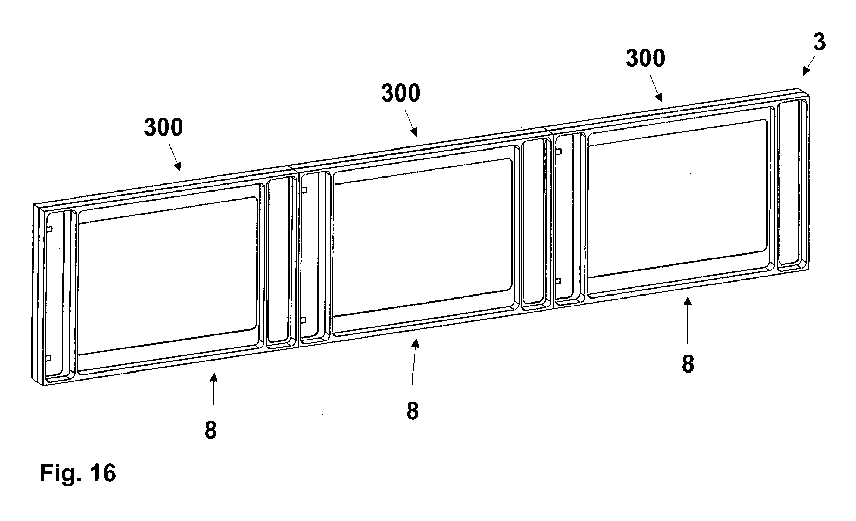

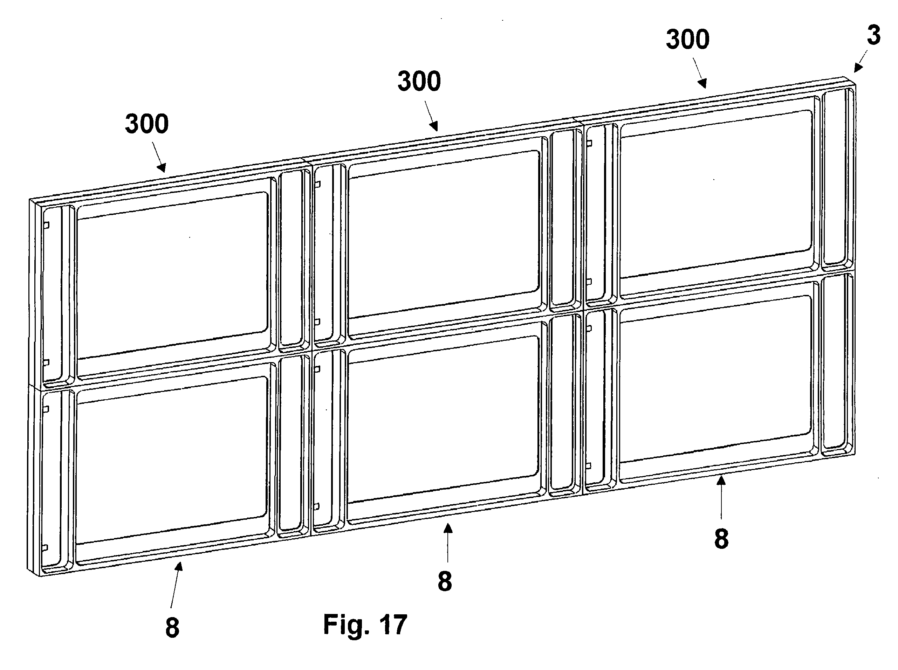

Die **Fig. 16** **und** **17** zeigen zwei verschiedene Anordnungen von mehreren Schubaktuatoren 300 gemäß Fig. 15 nebeneinander, die z. B. als aktiver Steg 3 bei einem Balken gemäß den Fig. 1 bis 3 Verwendung finden können.

### BEZUGSZEICHENLISTE

- 1: Obergurt
- 2: Untergurt
- 3: Steg
- 4: aktives Flächenmaterial
- 5: Stützsteg
- 6: Halbschale
- 7: Halbschale
- 8: Rahmen
- 9: Stützstrebe
- 10: Festkörpergelenk
- 11: Anschlusskontakt
- 14: Befestigungsloch
- 16: Bohrung
- 17: Absatz
- 18: Tasche
- 19: Matrix
- 30: Stegfeld
- 40: Nebenbereich
- 50: Stützgurt
- 55: Stegbegrenzung
- 100: Doppel-T-Träger
- 101: Anschlusselement
- 102: Anschlusselement
- 120: Pfeil
- 130: Pfeil
- 140: Zwischenelement
- 144: Zwischenrahmen
- 145: weiche Innenstruktur
- 150: Stützgurt
- 160: Hohlraum
- 161: Füllelement
- 162: Innenstrukturmusterung
- 200: U-Träger
- 300: Schubaktuator

## Patentansprüche

1. Aktuator mit einem aktiven Flächenmaterial, das in einer in seiner Haupterstreckungsebene verlaufenden Verformungshauptrichtung auf Expansion und/oder Kontraktion ansteuerbar ist und das in einem in seiner Haupterstreckungsebene verlaufenden und in dieser Haupterstreckungsebene geschlossenen, aber schubweichen Rahmen (8) angeordnet ist, wobei der Rahmen (8) zwei Paare von einander gegenüberliegenden und parallel zueinander verlaufenden Seiten aufweist, die ohne Zwischenschaltung weiterer Seiten des Rahmens miteinander verbunden sind, wobei alle Seiten des Rahmens (8) fest mit dem aktiven Flächenmaterial (4) verbunden sind und wobei die Verformungshauptrichtung des ansteuerbaren aktiven Flächenmaterials (4) zu allen Seiten des Rahmens (8) geneigt verläuft, **dadurch gekennzeichnet, dass** der Aktuator ein Schubaktuator ist, bei dem ein Paar der einander gegenüberliegenden Seiten des Rahmens (8) als Anschlusselemente (101 und 102) und das andere Paar der einander gegenüberliegenden Seiten des Rahmens (8) als in der Haupterstreckungsebene des Rahmens (8) biegeweiche Stützstege (5) oder Stützgurte (50) ausgebildet ist, so dass die Anschlusselemente (101 und 102) bei Ansteuerung des aktiven Flächenmaterials (4) in seiner Verformungshauptrichtung auf Expansion oder Kontraktion in entgegen gesetzter Richtung parallel gegeneinander verschoben werden.

2. Schubaktuator nach Anspruch 1, **dadurch gekennzeichnet, dass** der Rahmen (8) eine rechteckige Grundform aufweist.

3. Schubaktuator nach einem der Ansprüche 1 und 2, **dadurch gekennzeichnet, dass** das aktive Flächenmaterial (4) mit innerhalb des Rahmens (8) vorgesehenen Abstützelementen gegen Beulen senkrecht zu seiner Haupterstreckungsebene abgestützt ist.

4. Schubaktuator nach Anspruch 3, **dadurch gekennzeichnet, dass** die Abstützelemente (9) das aktive Flächenmaterial (4) beidseitig abstützen.

5. Schubaktuator nach einem der Ansprüche 3 und 4, **dadurch gekennzeichnet, dass** die Abstützelemente das aktive Flächenmaterial (4) vollflächig abstützen.

6. Schubaktuator nach einem der Ansprüche 3 und 4, **dadurch gekennzeichnet, dass** die Abstützelemente den Rahmen (8) unterteilende Stützstreben (9) aufweisen.

7. Schubaktuator nach einem der Ansprüche 1 bis 6, **dadurch gekennzeichnet, dass** mehrere Rahmen (8), in denen das aktive Flächenmaterial (4) angeordnet ist, so nebeneinander angeordnet sind, dass mindestens zwei Seiten von zwei einander benachbarten Rahmen durch dasselbe Bauelement (5, 50) ausgebildet sind.

8. Schubaktuator nach einem der Ansprüche 1 bis 7, **dadurch gekennzeichnet, dass** das eine Paar der einander gegenüberliegenden Seiten des Rahmens (8) mit sich längs dieser Seiten erstreckenden und senkrecht zu der Haupterstreckungsebene des Rahmens (8) ausgerichteten Gurten (1 und 2) verbunden ist.

9. Träger mit einem mindestens einen Schubaktuator nach einem der Ansprüche 1 bis 7 aufweisenden Steg (2) und zwei durch den Steg (3) verbundenen Gurten (1 und 2).

10. Doppel-T-Träger nach Anspruch 9.

11. U-Träger nach Anspruch 9.

## Claims

1. Actuator comprising an active plane material which is controllable for expansion and/or contraction in a main direction of deformation running within its plane of main extension, and which is arranged in a frame (8) being closed within this plane of main extension but soft with regard to shearing, wherein the frame (8) comprises two pairs of sides opposing each other and running in parallel to each other, which are connected to each other without interconnection of further sides of the frame, wherein all sides of the frame (8) are fixedly connected to the active plane material (4) and wherein the main direction of deformation of the controllable active plane material (4) is inclined with regard to all sides of the frame (8), **characterized in that** the actuator is a shear actuator in which one pair of the sides of the frame (8) opposing each other are connector elements (101 and 102) and the other pair of sides of the frame (8) opposing each other are made as bending-soft supporting webs (5) or supporting belts (50) running in the plane of main extension of the frame so that, upon controlling the active plane material (4) in its main direction of deformation for expansion or contraction, the connector elements (101 and 102) are moved in opposite directions in parallel with regard to each other.

2. Shear actuator according to claim 1, **characterized in that** the frame (8) comprises a rectangular basic form.

3. Shear actuator according to any of the claims 1 and 2, **characterized in that** the active plane material (4) is supported against buckling perpendicular to its plane of main extension by means of supporting elements provided within the frame (8).

4. Shear actuator according to claim 3, **characterized in that** the supporting elements (9) support the active plane material (4) on both sides.

5. Shear actuator according to any of the claims 3 and 4, **characterized in that** the supporting elements support the active plane material (4) over its entire surface.

6. Shear actuator according to any of the claims 3 and 4, **characterized in that** the supporting elements comprise supporting struts (9) subdividing the frame (8).

7. Shear actuator according to any of the claims 1 to 6, **characterized in that** several frames (8) in which the active plane material (4) is arranged are arranged side by side to each other in such a way that at least two sides of two adjacent frames are formed by the same construction element (5, 50).

8. Shear actuator according to any of the claims 1 to 7, **characterized in that** the one pair of the sides of the frame (8) opposing each other is connected to belts (1 and 2) extending along these sides and perpendicular to the plane of main extension of the frame (8).

9. Beam comprising a web (2) including at least one shear actuator according to any of the claims 1 to 7 and two belts (1 and 2) connected by the web (3).

10. H-beam according to claim 9.

11. U-beam according to claim 9.

## Revendications

1. Actionneur de poussée doté d'un matériau de surface actif, qui peut être activé au niveau de l'expansion et/ou de la contraction dans une direction principale de déformation, s'étendant dans son plan d'extension principal, et qui est disposé dans un cadre (8) agencé dans son plan d'extension principal et fermé dans ce plan d'extension principal, mais souple en poussée, le cadre (8) présentant deux paires de côtés se faisant face et s'étendant parallèlement entre eux, qui sont reliés les uns aux autres sans intercalation d'autres côtés du cadre, tous les côtés du cadre (8) étant reliés fixement au matériau de surface actif (4) et la direction principale de déformation du matériau de surface (4) activable s'étendant de façon inclinée vers tous les côtés du cadre (8), **caractérisé en ce que** l'actionneur est un actionneur de poussée, sur lequel une paire des côtés se faisant face du cadre (8) est conçue sous forme d'éléments de raccordement (101 et 102) et l'autre paire des côtés se faisant face du cadre (8) sous forme d'entretoises de soutien (5) ou sangles de soutien (50) souples en flexion dans le plan d'extension principal du cadre (8), de sorte que les éléments de raccordement (101 et 102) sont déplacés parallèlement les uns par rapport aux autres dans le sens opposé en cas d'actionnement du matériau de surface (4) actif dans sa direction principale de déformation au niveau de l'expansion ou de la contraction.

2. Actionneur de poussée selon la revendication 1, **caractérisé en ce que** le cadre (8) présente une forme de base rectangulaire.

3. Actionneur de poussée selon l'une des revendications 1 et 2, **caractérisé en ce que** le matériau de surface actif (4) est soutenu avec des éléments de soutien prévus à l'intérieur du cadre (8) contre les bosses perpendiculairement à son plan d'extension principal.

4. Actionneur de poussée selon la revendication 3, **caractérisé en ce que** les éléments de soutien (9) soutiennent des deux côtés le matériau de surface (4) actif.

5. Actionneur de poussée selon l'une des revendications 3 et 4, **caractérisé en ce que** les éléments de soutien soutiennent le matériau de surface (4) actif sur toute la surface.

6. Actionneur de poussée selon l'une des revendications 3 et 4, **caractérisé en ce que** les éléments de soutien présentent des entretoises (9) subdivisant le cadre (8).

7. Actionneur de poussée selon l'une des revendications 1 à 6, **caractérisé en ce que** plusieurs cadres (8) dans lesquels le matériau de surface (4) actif est disposé, sont disposés les à côtés des autres de telle sorte qu'au moins deux côtés de deux cadres voisins l'un de l'autre sont formés par le même élément de construction (5, 50).

8. Actionneur de poussée selon l'une des revendications 1 à 7, **caractérisé en ce que** l'une des paires des côtés se faisant face du cadre (8) est reliée à des sangles (1 et 2) s'étendant le long de ces côtés et orientées perpendiculairement au plan d'extension principal du cadre (8).

9. Support doté d'au moins une entretoise (2) présentant un actionneur de poussée selon l'une des revendications 1 à 7 et de deux sangles (1 et 2) reliées par l'entretoise (3).

10. Poutre en double T selon la revendication 9.

11. Poutre en U selon la revendication 9.
